# EUROPÄISCHE PATENTANMELDUNG

(11) **EP 4 667 688 A1**
(43) Veröffentlichungstag der Anmeldung: **24.12.2025**
(21) Anmeldenummer: 25182861.2
(22) Anmeldetag: 15.06.2025
(51) Int. Cl.: E05B 81/76, E05F 15/71, H03K 17/945, H03K 17/96

(54) **VERFAHREN ZUR DETEKTION EINER BETÄTIGUNG EINER ZUGANGSVORRICHTUNG EINES FAHRZEUGES**

(30) Priorität: 21.06.2024 DE 102024117662
(71) Anmelder: Huf Hülsbeck & Fürst GmbH & Co. KG, 42551 Velbert (DE)
(72) Erfinder: Yomkil Malabo, Jean, 42897 Remscheid (DE)
(74) Vertreter: Bösherz Goebel Patentanwälte

(57) **Zusammenfassung**

Die Erfindung betrifft ein Verfahren (100) zur Detektion einer Betätigung einer Zugangsvorrichtung (10) eines Fahrzeuges (1), wobei die Detektion der Betätigung in Abhängigkeit von Beurteilungsfaktoren vorgesehen ist, umfassend:
- Bereitstellen (101) von Sensorsignalen (210), welche aus einer Sensorerfassung am Fahrzeug (1) resultieren,
- Detektieren (102) einer Störung durch wenigstens einen Einfluss aus einer Umgebung (5) des Fahrzeuges (1), welche geeignet ist, die Detektion der Betätigung zu beeinträchtigen,
- Klassifizieren (103) einer Art der detektierten Störung durch eine Auswertung (103a) der bereitgestellten Sensorsignale (210),
- Anpassen (104) der Beurteilungsfaktoren für die Detektion der Betätigung auf Basis der Klassifizierung (103).

## Beschreibung

Die vorliegende Erfindung betrifft ein Verfahren zur Detektion einer Betätigung einer Zugangsvorrichtung eines Fahrzeuges. Ferner bezieht sich die Erfindung auf ein Trainingsverfahren für ein Maschinenlernmodell, ein Maschinenlernmodell, ein Computerprogramm, ein System sowie eine Vorrichtung zur Datenverarbeitung.

### Stand der Technik

Es ist aus dem Stand der Technik bekannt, dass eine Sensorik am Fahrzeug zur Erfassung von Betätigungshandlungen bei einem feststehenden Türgriff genutzt werden kann. Entsprechende Verfahren nutzen bspw. Annäherungssensoren, um Bewegungen oder Berührungen des Türgriffs zu erkennen.

Allerdings sind diese Verfahren oft fehleranfällig und können ungenaue Ergebnisse liefern. Zudem können sie durch äußere Einflüsse wie Regen, Schnee, Vibrationen oder Temperaturschwankungen beeinträchtigt werden.

### Offenbarung der Erfindung

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte Detektion einer Betätigung zu ermöglichen.

Gegenstand der Erfindung ist ein Verfahren mit den Merkmalen des Anspruchs 1, ein Trainingsverfahren mit den Merkmalen des Anspruchs 16, ein Maschinenlernmodell mit den Merkmalen des Anspruchs 17, ein Computerprogramm mit den Merkmalen des Anspruchs 18 sowie eine Vorrichtung mit den Merkmalen des Anspruchs 19 und ein System mit den Merkmalen des Anspruchs 20.

Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Trainingsverfahren, dem erfindungsgemäßen Maschinenlernmodell, dem erfindungsgemäßen System, dem erfindungsgemäßen Computerprogramm sowie der erfindungsgemäßen Vorrichtung, und jeweils umgekehrt, so dass bezüglich der Offenbarung der Erfindung stets auch eine wechselseitige Bezugnahme möglich ist.

Gegenstand der Erfindung ist insbesondere ein Verfahren zur Detektion einer Betätigung einer Zugangsvorrichtung eines Fahrzeuges. Dabei kann die Detektion der Betätigung in Abhängigkeit von Beurteilungsfaktoren vorgesehen sein, auf welche nachfolgend noch näher eingegangen wird.

Das Fahrzeug kann bspw. als ein Personenkraftfahrzeug und/oder ein Lastkraftfahrzeug ausgebildet sein. Vorzugsweise weist das Fahrzeug für sicherheitsrelevanten Funktionen wie zum Öffnen und/oder Schließen und/oder Verriegeln und/oder Entriegeln zumindest eine oder mehrere Zugangsvorrichtungen wie Türgriffe auf. Dabei kann zumindest eine der genannten Funktionen aktiviert werden, wenn eine Betätigung bei der Zugangsvorrichtung detektiert wird. Die jeweilige Zugangsvorrichtung kann dabei ein feststehender Türgriff sein, welcher unbeweglich am Fahrzeug angeordnet sein und/oder ohne eine mechanische Betätigungsvorrichtung auskommen kann. Die Betätigung kann vielmehr durch eine Sensorerfassung einer, ggf. berührungslosen, Betätigungshandlung detektiert werden.

Das erfindungsgemäße Verfahren umfasst insbesondere ein Bereitstellen von Sensorsignalen, welche aus einer Sensorerfassung am Fahrzeug resultieren. Dies kann bedeuten, dass die Sensorsignale in digitaler Form empfangen werden, vorzugsweise von ein oder mehreren Sensoren, die am Fahrzeug angeordnet sind. Die Bereitstellung und insbesondere das Empfangen der Sensorsignale kann durch ein Computerprogramm erfolgen, welches bspw. durch eine Vorrichtung wie einen Mikrocontroller der Zugangsvorrichtung ausgeführt wird. Ferner können ein oder mehrere Sensoren am Fahrzeug und vorzugsweise an der Zugangsvorrichtung vorgesehen sein, um die Sensorerfassung durchzuführen und die Sensorsignale auszugeben. Um die Sensorsignale empfangen zu können, ist es möglich, dass der jeweilige Sensor über Funk und/oder über ein Kabel mit der Vorrichtung verbunden ist. Weiter ist es denkbar, dass bei mehreren Sensoren die Sensorsignale eine digitale Kennzeichnung aufweisen oder damit versehen werden, die angibt, von welchem der Sensoren ein jeweiliges Sensorsignal stammt. Dies ist insbesondere dann nützlich, wenn es bei der weiteren Verarbeitung der Sensorsignale eine Rolle spielt, an welcher Position ein Sensor angeordnet ist und/oder welche Sensorart für die Sensorerfassung genutzt wurde.

Das erfindungsgemäße Verfahren kann ferner ein Detektieren einer Störung umfassen. Die Störung kann dabei durch wenigstens einen Einfluss aus einer Umgebung des Fahrzeuges verursacht werden. Weiter kann die Störung geeignet sein, die Detektion der Betätigung zu beeinträchtigen. Da die Detektion zur Auslösung einer sicherheitsrelevanten Funktion dienen kann, wie bspw. das Öffnen einer Fahrzeugtür, ist die Detektion der Störung oft von entscheidender Bedeutung. Hierzu können bspw. die Sensorsignale ausgewertet werden, um nicht nur die Betätigung zu detektieren, sondern auch etwaige Störeinflüsse in der Umgebung zu erkennen und damit das Vorliegen der Störung zu detektieren. Dabei sind verschiedene Arten von Störungen denkbar. Diese umfassen z. B. Störungen durch Regen, Störungen durch Schnee oder Störungen durch Wischbewegungen an der Zugangsvorrichtung. Die Arten von Störungen können dabei so vielseitig sein wie die Arten von Einflüssen aus der Umgebung. Die voranstehend beschriebene Detektion der Störung umfasst jedoch noch nicht die Ermittlung der Art der Störung.

Die vorliegende Erfindung beruht unter anderem auf der Erkenntnis, dass eine Berücksichtigung nicht nur des Vorliegens, sondern auch der Art der Störung die Detektion der Betätigung deutlich robuster gestalten kann. Daher kann das Verfahren ein Klassifizieren der Art der detektierten Störung durch eine Auswertung der bereitgestellten Sensorsignale umfassen. Dies ermöglicht es, eine Anpassung der Beurteilungsfaktoren für die Detektion der Betätigung auf Basis der Klassifizierung vorzunehmen. Somit kann das Verfahren eine genauere und zuverlässigere Detektion der Betätigung einer Zugangsvorrichtung eines Fahrzeuges ermöglichen. Während die Detektion, dass überhaupt eine Störung vorliegt, bereits einen positiven Einfluss auf die Detektion der Betätigung hat, kann die genaue Bestimmung der Art der Störung eine Feinabstimmung der Beurteilungsfaktoren bieten. Insbesondere kann sich die Anpassung der Beurteilungsfaktoren darauf auswirken, in welcher Weise und/oder in welchem Ausmaße, vorzugsweise mit welcher Gewichtung, die Sensorsignale von unterschiedlichen Sensoren bei der Detektion der Betätigung berücksichtigt werden. Dies kann auch als eine Optimierung der Beurteilungsfaktoren verstanden werden.

Erfindungsgemäß wird daher vorzugsweise nicht nur das Vorliegen, sondern zusätzlich auch die Art der Störungen aus der Umgebung des Fahrzeuges berücksichtigt. Durch die Auswertung der Sensorsignale kann die Klassifizierung der detektierten Störungen ermöglicht werden, was wiederum zur Verbesserung der Beurteilungsfaktoren für die Detektion der Betätigung führen kann. Dies ermöglicht eine optimale Detektion und minimiert falsch positive Ergebnisse.

Ferner können Ergebnisse des Verfahrens optional auch im störungsfreien Betrieb dazu verwendet werden, um die Zuverlässigkeit und Leistung bei der Detektion der Betätigung zu verbessern. Hierzu werden bspw. Störungen und Einflüsse aus der Umgebung identifiziert und deren Einfluss reduziert. Durch die Anpassung der Beurteilungsfaktoren kann außerdem eine bessere Anpassung an bestimmte Situationen erreicht werden, wie z.B. in einer Waschstraße oder in rauen Wetterbedingungen.

Die Betätigung kann z. B. durch eine oder verschiedene Betätigungshandlungen erfolgen, welche am Fahrzeug durch einen Benutzer durchgeführt werden. Dabei können im Rahmen der Sensorerfassung ein oder mehrere Sensoren genutzt werden, um die Betätigungshandlung zu erfassen und somit die Betätigung zu detektieren. Für die Detektion der Betätigung können bspw. die gleichen Sensorsignale ausgewertet werden, welche auch zur Klassifizierung der Art der Störung ausgewertet werden. Die Beurteilungsfaktoren sind vorzugsweise Faktoren wie Gewichtungen, welche bestimmen, in welchem Ausmaße und/oder nach welchen Kriterien die Sensorsignale für die Detektion der Betätigung berücksichtigt werden.

Weiter ist im Rahmen der Erfindung denkbar, dass das Anpassen der Beurteilungsfaktoren für die Detektion der Betätigung auf Basis der Klassifizierung eine Optimierung der Beurteilungsfaktoren hinsichtlich der Art der Störung umfasst, welche zusätzlich und/oder nachfolgend zu einer ersten Anpassung der Beurteilungsfaktoren durchgeführt wird. Die erste Anpassung kann bspw. direkt durchgeführt werden, sobald detektiert wird, dass überhaupt eine Störung vorliegt. Damit kann schnell auf eine Störung reagiert werden, um zu verhindern, dass es zu einer fehlerhaften Detektion und Aktivierung der Zugangsvorrichtung aufgrund des Störeinflusses kommt. Anschließend kann, weniger zeitkritisch, die Anpassung auf Basis der Klassifizierung als eine weitere Anpassung der Beurteilungsfaktoren vorgesehen sein. Somit kann die Klassifizierung und die Anpassung auf Basis der Klassifizierung erst verzögert nach der ersten Anpassung vorgesehen sein.

Ferner können vor der Detektion der Störung die Beurteilungsfaktoren derart eingestellt sein, dass die Detektion der Betätigung mit einer normalen Sensitivität erfolgt, um die Zugangsvorrichtung zu aktivieren, wenn die Betätigung erkannt (detektiert) worden ist. Sodann kann ausgelöst durch die Detektion der Störung die erste Anpassung der Beurteilungsfaktoren erfolgen, um in einem gestörten Modus die Detektion der Betätigung in einen robusteren Modus zu überführen. In diesem kann die Detektion der Betätigung mit einer geringeren Sensitivität erfolgen und/oder die Aktivierung der Zugangsvorrichtung vorrübergehend unterdrückt werden.

Weiter kann nach der Überführung in den robusteren Modus zusätzlich die Klassifizierung der Art der detektierten Störung erfolgen. Es können dadurch auf Basis der Klassifizierung die Beurteilungsfaktoren hinsichtlich der Art der Störung optimiert werden. Für die erfindungsgemäße Anpassung der Beurteilungsfaktoren auf Basis der Klassifizierung werden die Beurteilungsfaktoren z. B. in Abhängigkeit von der Art der Störung eingestellt. Dies ist bspw. durch die Verwendung eines regelbasierten Algorithmus und/oder einer Lookup-Tabelle und/oder eines maschinellen Lernalgorithmus möglich. Für die Klassifizierung selbst sind ebenfalls eine Vielzahl von Algorithmen denkbar, z. B. Mustererkennungsalgorithmen, ein Schwellenwertvergleich oder neuronale Netze.

Weiter kann zur Detektion der Betätigung eine Detektionsauswertung zumindest eines Teils der bereitgestellten Sensorsignale in Abhängigkeit von den Beurteilungsfaktoren durchgeführt werden. Die Detektionsauswertung umfasst bspw. eine Merkmalsextraktion und/oder eine Signalfilterung und/oder eine Rauschdetektion und/oder eine Rauschklassifizierung und/oder eine Auswertung der Signalform der Sensorsignale.

Die Detektion der Betätigung in Abhängigkeit von den Beurteilungsfaktoren kann bspw. so durchgeführt werden, dass die Beurteilungsfaktoren eine Gewichtung definieren, und die Sensorsignale von unterschiedlichen Sensoren entsprechend der Gewichtung unterschiedlich berücksichtigt werden. Mit anderen Worten können die Sensoren unterschiedlich gewichtet und damit unterschiedlich stark für die Detektion der Betätigung berücksichtigt werden.

Die beschriebe Verarbeitung der Sensorsignale ermöglicht es, dass eine robustere Detektion der Betätigung erreicht werden, insbesondere in Situationen, die die Sensorsignale stören. Neben der Erhöhung der Robustheit der Detektion gegenüber Störungen durch externe Einflüsse kann ggf. auch eine Anpassung an verschiedene Situationen und Umgebungen und/oder eine Verbesserung der Genauigkeit der Betätigungserkennung möglich sein. Weiterhin kann die Klassifizierung der Art der detektierten Störung dazu beitragen, dass die Beurteilungsfaktoren auf Basis der Art der Störung optimiert werden. Dies ermöglicht eine Verbesserung des Systems für bestimmte Situationen und Umgebungen. Darüber hinaus können auch verschiedene Modi für das System vorgesehen sein. Zum Beispiel kann es in einem normalen Modus betrieben werden, wenn die Umgebung stabil ist, und in einem robusteren Modus, wenn die Umgebung instabil oder störend ist. Dies ermöglicht eine flexible Anpassung an verschiedene Situationen und Umgebungen.

Es ist ferner denkbar, dass die Sensorerfassung durch mehrere Sensoren am Fahrzeug vorgesehen ist, welche sich hinsichtlich ihrer Sensortechnologie und/oder Erfassungsart und/oder ihrer Anordnung am Fahrzeug unterscheiden, um den wenigstens einen Einfluss aus der Umgebung und insbesondere auch wenigstens eine Betätigungshandlung für die Detektion der Störung und/oder Betätigung zu erfassen. Dabei können die Sensoren hierzu bevorzugt an der Zugangsvorrichtung angeordnet, bevorzugt befestigt, sein. Dies hat den Vorteil, dass eine Vielzahl von Informationen über die Umgebung und die Betätigungshandlung erfasst werden können, um so eine genauere Detektion der Störung und einer möglichen Betätigung zu ermöglichen. Durch die Verwendung mehrerer Sensoren mit unterschiedlichen Sensortechnologien und Anordnungen am Fahrzeug können auch verschiedene Aspekte der Umgebung und der Betätigungshandlung berücksichtigt werden, wie z.B. die Geschwindigkeit oder Richtung der Bewegung. Dadurch kann eine bessere Klassifizierung der Störung und einer möglichen Betätigung erreicht werden, was zu einer genaueren Detektion und einer verbesserten Zuverlässigkeit des Systems führt.

Es kann weiter möglich sein, dass das Anpassen der Beurteilungsfaktoren für die Detektion der Betätigung umfasst: Anpassen einer Detektionsgewichtung, mit welcher die Sensorsignale von unterschiedlichen Sensoren für die Detektion der Betätigung berücksichtigt werden. Mit anderen Worten können Sensorsignale von unterschiedlichen Sensoren entsprechend der Detektionsgewichtung unterschiedlich gewichtet werden. Somit kann das Anpassen der Beurteilungsfaktoren eine erhebliche Verbesserung bei der Zuverlässigkeit und Genauigkeit der Detektion der Betätigung von Zugangsvorrichtungen eines Fahrzeuges bringen. Durch die Verwendung einer Detektionsgewichtung können die Sensorsignale von verschiedenen Sensoren mit unterschiedlichem Ausmaße berücksichtigt werden, was insbesondere dann von Vorteil ist, wenn die Umgebung des Fahrzeuges sehr reich an Störquellen ist. Dabei können dank der Klassifizierung diejenigen Sensoren am meisten berücksichtigt werden, die typischerweise am wenigsten von der ermittelten Art der Störung beeinflusst werden. Dies führt zu einem umfassenderen und genauer Verständnis der Sensorsignale und einer reduzierten Fehlalarmquote. Durch die Anpassung kann auch eine bessere Trennung zwischen nützlichen und störenden Signalen erreicht werden, was eine positive Auswirkung auf die Detektion haben kann.

Auch ist es optional denkbar, dass bei dem Anpassen der Detektionsgewichtung diejenigen der Sensorsignale, welche von einer ersten Sensorerfassung wenigstens eines ersten Sensors resultieren, die stärker durch den wenigstens einen Einfluss beeinträchtig wird, geringer gewichtet werden als diejenigen der Sensorsignale, welche von einer zweiten Sensorerfassung wenigstens eines zweiten Sensors resultieren, die weniger als die erste Sensorerfassung durch den wenigstens einen Einfluss beeinträchtig wird. Mit anderen Worten können diejenigen Sensoren in einem verringerten Ausmaße für die Detektion der Betätigung berücksichtigt werden, die typischerweise am meisten von der ermittelten Art der Störung beeinflusst werden. Damit wird der Vorteil erzielt, dass die Detektionsgenauigkeit bei störenden Umgebungsbedingungen verbessert werden kann. Durch das Anpassen der Detektionsgewichtung an die unterschiedliche Beeinträchtigung der Sensorsignale können Störsignale ggf. effizienter ausgefiltert werden, was zu einer reduzierten Fehlerquote führt. Diese Anpassung ermöglicht es auch, dass die Systemleistung bei verschiedenen Umgebungsbedingungen angepasst werden kann, um eine maximale Genauigkeit zu erreichen. Durch die adaptive Gewichtung der Sensorsignale kann das System vorzugsweise angepasst werden, um auf Störungen zu reagieren, die von einer bestimmten Sensorposition oder Empfindlichkeit stammen. Insgesamt ermöglicht diese Anpassung eine Erhöhung der Detektionsgenauigkeit und Robustheit des Systems bei verschiedenen Umgebungsbedingungen.

Es kann ferner möglich sein, dass das Klassifizieren der Art der detektierten Störung umfasst: Verwenden einer unterschiedlichen Gewichtung in Abhängigkeit von der zu klassifizierenden Art der detektierten Störung, mit welcher die Sensorsignale von unterschiedlichen Sensoren bei der Auswertung berücksichtigt werden, um die Art der detektierten Störung zu ermitteln. Dies beruht auf der Erkenntnis, dass verschiedene Sensoren (z B. verschiedenartig und/oder an verschiedenen Positionen angeordnet) eine unterschiedliche Aussagekraft für unterschiedliche Arten von Störungen haben. Je nach Art der zu klassifizierenden Störung können daher die unterschiedlichen Sensoren unterschiedlich stark berücksichtigt werden. Auf diese Weise ist es möglich, dass das Klassifizieren der Art der detektierten Störung durch eine intelligente Gewichtung von Sensorsignalen flexibler und genauer wird. Durch die Verwendung unterschiedlicher Gewichtungen in Abhängigkeit von der zu klassifizierenden Art der detektierten Störung kann das System sinnvoll auf die jeweiligen Eigenschaften der verschiedenen Sensoren reagieren. Dies ermöglicht auch eine bessere Interpretation von Sensorsignalen, insbesondere wenn die Störungen unterschiedliche Merkmale aufweisen. Durch diese Flexibilität kann das System besser an veränderte Umgebungsbedingungen angepasst werden und eine höhere Genauigkeit bei der Detektion von Störungen erreichen.

Für die Anpassung der Gewichtung können eine oder mehrere Gewichtungsvorgaben vordefiniert sein, und z. B. über eine Lookup-Tabelle oder dergleichen abgerufen werden. Somit kann es von Vorteil sein, wenn im Rahmen der Erfindung für die verschiedenen Arten von Störungen unterschiedliche Gewichtungsvorgaben definiert sind, mit welchen die Sensorsignale zur Ermittlung der Art der detektierten Störung ausgewertet werden. Dabei können hierzu vorzugsweise bei dem Klassifizieren diejenigen der Sensorsignale, welche von einer ersten Sensorerfassung wenigstens eines ersten Sensors resultieren, die (typischerweise, z. B. aufgrund einer empirischen Erkenntnis) stärker durch die zu klassifizierende Art der detektierten Störung beeinträchtig wird, höher gewichtet werden als diejenigen der Sensorsignale, welche von einer zweiten Sensorerfassung wenigstens eines zweiten Sensors resultieren, die weniger als die erste Sensorerfassung durch die zu klassifizierende Art der detektierten Störung beeinträchtig wird. Dadurch kann eine genauere Klassifizierung von Störungen erreicht werden, da die Sensorsignale auf ihre besondere Bedeutung für die Detektion einer bestimmten Art von Störung ausgerichtet sind. Durch die verschiedenen Gewichtungsvorgaben kann das System flexibel auf verschiedene Umgebungsbedingungen reagieren und die Auswirkungen der Störungen auf die Sensorsignale berücksichtigen.

In einer weiteren Möglichkeit kann vorgesehen sein, dass für die Sensorsignale von unterschiedlichen Sensoren jeweils die Auswertung durchgeführt wird, um für jeden Sensor die Klassifizierung individuell durchzuführen. Dabei können anschließend die Ergebnisse der Klassifizierungen verglichen werden, um zu entscheiden, welche Art der Störung vorliegt. Durch diese individualisierte Klassifizierung kann die Wahrscheinlichkeit einer falschen Störungsdiagnose reduziert werden, was insbesondere bei der Detektion von Störungen in einem Fahrzeugumfeld von Bedeutung ist. Die Vergleichsphase zwischen den Ergebnissen der Klassifizierungen ermöglicht eine weitere Verbesserung der Genauigkeit und kann auch zur Identifikation von Störungen verwendet werden, die aufgrund ihrer Schwäche oder Ausprägung nicht leicht erkennbar sind.

Ferner ist es optional vorgesehen, dass die zu klassifizierende Art der zu detektierenden Störung zumindest eine der folgenden umfasst: Regen, Hagel, Schnee, Vibration, mechanische Einwirkungen wie eine Reinigungsbewegung, Spritzwasser, Feuchtigkeit, Luftturbulenzen, Blätter, Tiere, Objekte. Dies ermöglicht eine genaue Analyse der Umgebungsbedingungen und Anpassung der Beurteilungsfaktoren für die Detektion der Betätigung.

Beispielsweise kann es vorgesehen sein, dass die Zugangsvorrichtung als ein feststehender Türgriff ausgebildet ist und/oder wenigstens eine Aktivierungsvorrichtung zur Aktivierung einer Tür und/oder Klappe, vorzugsweise Heckklappe, des Fahrzeuges umfasst. Dabei können die Sensorsignale von mehreren Sensoren resultieren, wobei jeder Sensor ein individuelles Sensorsignal liefert. Weiter können bei der Detektion der Betätigung und/oder bei der Auswertung diesen Sensorsignalen unterschiedliche Beurteilungsfaktoren zugewiesen werden, welche die relative Bedeutung der Sensorsignale für die Detektion repräsentieren. Dies ermöglicht eine genaue Analyse der Umgebungsbedingungen und Anpassung der Beurteilungsfaktoren für die Detektion der Betätigung.

Vorzugsweise können die Sensoren zumindest einen der folgenden umfassen: kapazitive Sensoren, induktive Sensoren, Dehnungsmessstreifen, Metallannäherungssensoren, optische Sensoren, Thermoelemente, Drucksensoren und Näherungssensoren. Die Verwendung von kapazitiven und/oder induktiven Sensoren ermöglicht eine genaue Detektion von Störungen in der Umgebung des Fahrzeugs. Die Dehnungsmessstreifen und Metallannäherungssensoren können die Position und den Abstand von Objekten detektieren, während optische Sensoren die Sichtbarkeit von Objekten überprüfen. Die Verwendung von Thermoelementen und Drucksensoren ermöglicht die Überwachung von Temperatur- und Druckänderungen in der Umgebung des Fahrzeugs, was ebenfalls bei der Identifizierung von Störungen hilfreich sein kann. Die Näherungssensoren können den Abstand von Objekten detektieren und die Position von Objekten im Verhältnis zur Zugangsvorrichtung überprüfen. Dies ermöglicht eine zuverlässige Detektion einer Betätigungshandlung wie eines Drücken oder Ziehen am feststehenden Türgriff.

Vorteilhafterweise kann im Rahmen der Erfindung vorgesehen sein, dass wenigstens ein erster Sensor für eine erste Sensorerfassung außenliegend an der Zugangsvorrichtung angeordnet ist, um als eine Betätigungshandlung zur Detektion der Betätigung eine Berührung und/oder ein Drücken an der Zugangsvorrichtung zu erfassen, durch welche bei erfolgreicher Detektion der Betätigung eine Entriegelung und/oder Verriegelung und/oder ein automatisches Türschließen initiiert wird.

Ferner kann wenigstens ein zweiter Sensor für eine zweite Sensorerfassung innenliegend an der Zugangsvorrichtung angeordnet sein, um als eine Betätigungshandlung zur Detektion der Betätigung ein Eingreifen und/oder Ziehen an der Zugangsvorrichtung zu erfassen, durch welche bei erfolgreicher Detektion der Betätigung eine Entriegelung und/oder ein automatisches Türöffnen initiiert wird. Mit innenliegend kann dabei gemeint sein, dass der wenigstens eine zweite Sensor in Richtung zum Fahrzeuginneren ausgerichtet ist. Dagegen kann der außenliegende wenigstens eine erste Sensor in entgegengesetzter Richtung ausgerichtet sein. Der wenigstens eine zweite Sensor kann ferner näher an einer Türgriffmulde angeordnet sein als der wenigstens eine erste Sensor. Die wenigstens einen ersten und wenigstens einen zweiten Sensoren können dabei in einem gemeinsamen Gehäuse der Zugangsvorrichtung vorgesehen sein.

Durch die Verwendung von Sensorsignalen aus verschiedenen Richtungen kann eine genaue Ermittlung der Betätigungshandlung erfolgen, was insbesondere bei der Verwendung von kapazitiven und/oder induktiven Sensoren von Vorteil ist.

Darüber hinaus kann auch wenigstens ein dritter Sensor für eine dritte Sensorerfassung vorgesehen sein, welcher derart am Fahrzeug/der Zugangsvorrichtung angeordnet ist, dass die dritte Sensorerfassung nicht oder im Wesentlichen nicht durch eine Betätigungshandlung beeinflusst wird. Somit kann der dritte Sensor dediziert dazu dienen, den Einfluss für die Detektion der Störung und/oder Art der Störung zu erfassen.

Es kann ferner möglich sein, dass die jeweilige Auswertung durch ein Maschinenlernmodell durchgeführt wird, welches vorzugsweise in der Form eines flachen neuronalen Netzwerkes und/oder eines neuronalen Netzwerkes mit maximal zehn oder maximal fünf oder maximal zwei Schichten, vorzugsweise einer Eingabe- und einer Ausgabeschicht, ausgebildet ist. Damit wird der Vorteil erzielt, dass die Auswertung durch ein Maschinenlernmodell automatisiert und effizienter wird. Durch die Verwendung eines flachen neuronalen Netzwerks oder eines Netzwerkes mit maximal zehn/fünf/zwei Schichten kann eine schnelle und zuverlässige Klassifizierung der Störungen erreicht werden. Dieses Modell kann optional auch dazu verwendet werden, die Auswirkungen von Umgebungsbedingungen auf die Sensorsignale zu kompensieren, was insbesondere in Anwendungen mit unzuverlässigen oder unstabilen Sensorsignale von Vorteil ist. Ferner ermöglicht das Modell die Identifizierung von Mustern und Abhängigkeiten zwischen den Eingangsdaten, was zur Verbesserung der Genauigkeit und Zuverlässigkeit der Auswertung beiträgt.

Optional ist es denkbar, dass das Maschinenlernmodell durch einen/auf einem Mikrocontroller ausgeführt wird, welcher vorzugsweise in die Zugangsvorrichtung integriert ist. Auf diese Weise ist es möglich, dass das Maschinenlernmodell direkt im Prozesskreis der Zugangsvorrichtung läuft und dadurch die Reaktionszeit auf veränderte Umgebungsbedingungen reduziert wird. Dies ermöglicht eine schnellere Anpassung an störende Faktoren, was zu einer Verbesserung der Genauigkeit und Zuverlässigkeit der Betätigungsdetektion führt. Durch die Integration des Mikrocontrollers in die Zugangsvorrichtung kann außerdem eine Verkürzung der Signalwege zwischen Sensor und Analysemodell erreicht werden, was zu einer verbesserten Datensammlung und -auswertung führt.

In einer weiteren Möglichkeit kann vorgesehen sein, dass für die jeweilige Auswertung als Eingabe für das Maschinenlernmodell mindestens 100 oder mindestens 200 oder mindestens 300 zeitlich aufeinanderfolgende Samples der Sensorsignale verwendet werden, wobei die Samples vorzugsweise in zeitlichen Abständen von 1 bis 10 ms, vorzugsweise 3 bis 7 ms erfasst werden. Dadurch kann die Genauigkeit der Detektion und Klassifizierung von Störungen erheblich verbessert werden, da eine größere Anzahl an zeitlich aufeinanderfolgenden Samples verwendet wird. Dies ermöglicht es dem Maschinenlernmodell, auch schwache Signalanteile besser zu erkennen und zu klassifizieren. Gleichzeitig werden die Hardwareanforderungen und -limitierungen hierbei berücksichtigt, um eine optimale Signalauswertung zu erhalten. Zudem ermöglicht die Verwendung einer größeren Anzahl an Samples eine genauere Klassifizierung von Störungen, da das Modell besser in der Lage ist, die Merkmale der verschiedenen Störungstypen zu unterscheiden. Dies kann dazu beitragen, dass die Detektion und Klassifizierung von Störungen genauer und sicherer erfolgt.

Nach einer weiteren Möglichkeit kann vorgesehen sein, dass eine Anzahl der Neuronen der Eingabeschicht in Abhängigkeit von einer Anzahl der als Eingabe verwendeten Samples definiert wird, und/oder dass eine Anzahl der Neuronen der Ausgabeschicht in Abhängigkeit von der Anzahl der zu klassifizierenden Arten der Störung definiert wird. Dies kann dazu beitragen, dass das neuronale Netzwerk sich an die spezifischen Anforderungen des Systems anpasst, um eine effektivere Fehlererkennung und -kompensation zu ermöglichen.

Ebenfalls Gegenstand der Erfindung ist ein Trainingsverfahren für ein Training eines Maschinenlernmodells zur Klassifizierung einer Art einer Störung durch wenigstens einen Einfluss aus einer Umgebung eines Fahrzeuges. Das Trainingsverfahren kann bevorzugt (vollständig) automatisiert und/oder als computerimplementiertes Verfahren durchgeführt werden.

Das Trainingsverfahren kann ein Bereitstellen von Trainingsdaten umfassen. Dabei können die Trainingsdaten mehrere Sensorsignale umfassen, die für jeweilige Sensorerfassungen von verschiedenen Sensoren bei einer Zugangsvorrichtung des Fahrzeuges spezifisch sind. Weiter können die Trainingsdaten den Sensorsignalen zugeordnete Referenzdaten umfassen, insbesondere in der Form eines Ground Truth, welche eine Art der Störung angeben, die bei der jeweiligen Sensorerfassung vorgesehen war. Die Trainingsdaten können dabei auf einer realen Sensorerfassung basieren und/oder augmentierte und/oder simulierte Daten aufweisen. Dies ermöglicht eine robustere und vielseitigere Modellierung der Daten und erhöht somit die Genauigkeit und Zuverlässigkeit der Ergebnisse.

Weiter kann das Trainingsverfahren ein Trainieren des Maschinenlernmodells auf Basis der bereitgestellten Trainingsdaten sowie ein Bereitstellen des trainierten Maschinenlernmodells für die Klassifizierung der Art einer beim Fahrzeug detektierten Störung umfassen. Damit bringt das erfindungsgemäße Trainingsverfahren die gleichen Vorteile mit sich, wie sie ausführlich mit Bezug auf ein erfindungsgemäßes Verfahren beschrieben worden sind.

Ebenfalls Gegenstand der Erfindung ist ein Maschinenlernmodell, welches durch ein erfindungsgemäßes Trainingsverfahren trainiert worden ist. Damit bringt das erfindungsgemäße Maschinenlernmodell die gleichen Vorteile mit sich, wie sie ausführlich mit Bezug auf die erfindungsgemäßen Verfahren beschrieben worden sind. Ferner kann das trainierte Maschinenlernmodell bei einem erfindungsgemäßen Verfahren zum Einsatz kommen.

Ebenfalls Gegenstand der Erfindung ist eine Vorrichtung zur Datenverarbeitung, umfassend Mittel zur Ausführung des erfindungsgemäßen Verfahrens. Damit bringt die erfindungsgemäße Vorrichtung zur Datenverarbeitung die gleichen Vorteile mit sich, wie sie ausführlich mit Bezug auf ein erfindungsgemäßes Verfahren beschrieben worden sind.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, zumindest eines der erfindungsgemäßen Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind. Das Computerprogramm kann ferner zumindest teilweise nicht-flüchtig und/oder als Software zum Download und/oder als Cloud-Service und/oder als ausführbares Programm und/oder als Konfigurationsdatei und/oder als Programmbibliothek und/oder als Quelltext und/oder in kompilierter und/oder verschlüsselter und/oder komprimierter Form und/oder in einer Kombination davon vorliegen.

Als der Computer kann eine Datenverarbeitungsvorrichtung, vorzugsweise die erfindungsgemäße Vorrichtung zur Datenverarbeitung, vorgesehen sein.

Die erfindungsgemäße Vorrichtung zur Datenverarbeitung und vorzugsweise der Computer kann dazu ausgebildet sein, das erfindungsgemäße Computerprogramm auszuführen. Hierzu kann die erfindungsgemäße Vorrichtung zur Datenverarbeitung wenigstens einen Prozessor aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann. Die erfindungsgemäße Vorrichtung bzw. der Computer kann bspw. als ein Mikrocontroller der Zugangsvorrichtung und/oder des Fahrzeuges ausgebildet sein.

Ebenfalls ist es denkbar, dass die erfindungsgemäße Vorrichtung zur Datenverarbeitung zumindest einen integrierten Schaltkreis wie einen Mikroprozessor oder eine Anwendungsspezifische integrierte Schaltung (ASIC) oder ein Anwendungsspezifisches Standardprodukt (ASSP) oder einen digitalen Signalprozessor (DSP) oder einen Field Programmable Gate Array (FPGA) oder dergleichen umfasst. Die erfindungsgemäße Vorrichtung zur Datenverarbeitung kann ferner wenigstens eine Schnittstelle zum Datenaustausch, z. B. eine Ethernet-Schnittstelle oder eine Schnittstelle für LAN (Local Area Network) oder WLAN (Wireless Local Area Network) oder System-on-a-Chip (SoC) oder eine andere Funkschnittstelle wie bspw. zur Bluetooth- oder Nahfeldkommunikation (NFC) aufweisen. Ferner kann die erfindungsgemäße Vorrichtung zur Datenverarbeitung als ein oder mehrere Steuergeräte, d. h. auch als ein System aus Steuergeräten, ausgeführt sein. Die erfindungsgemäße Vorrichtung zur Datenverarbeitung kann vollständig oder teilweise auch in einer Cloud und/oder als ein Server vorgesehen sein, um über die Schnittstelle die Datenverarbeitung für eine lokale Anwendung zur Verfügung zu stellen. Entsprechend kann die erfindungsgemäße Vorrichtung zur Datenverarbeitung auch als ein verteiltes System ausgebildet sein. Auch ist es möglich, dass die erfindungsgemäße Vorrichtung zur Datenverarbeitung als ein mobiles Gerät, wie ein Smartphone, ausgeführt ist.

Ebenfalls Gegenstand der Erfindung kann ein computerlesbares Speichermedium sein, welches das erfindungsgemäße Computerprogramm umfasst. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer und/oder in die erfindungsgemäße Vorrichtung zur Datenverarbeitung integriert sein.

Außerdem Gegenstand der Erfindung ist ein System zur Detektion einer Betätigung einer Zugangsvorrichtung eines Fahrzeuges, wobei die Detektion der Betätigung in Abhängigkeit von Beurteilungsfaktoren vorgesehen ist. Das System kann mehrere Sensoren verschiedener Art umfassen, z. B. kapazitive und/oder induktive Sensoren, welche zur Erfassung einer Umgebung des Fahrzeuges über verschiedene Erfassungsprinzipien (auch Erfassungsarten bezeichnet) vorgesehen sind, um über die Sensorerfassung jeweils (digitale) Sensorsignale bereitzustellen. Ferner kann eine Vorrichtung, vorzugsweise erfindungsgemäße Vorrichtung, zur Datenverarbeitung vorgesehen sein, welche die bereitgestellten Sensorsignale erfasst und dazu ausgeführt ist, für die Anpassung der Beurteilungsfaktoren das erfindungsgemäße Verfahren auszuführen.

Die Erfassungsprinzipien (Erfassungsarten) können dabei wenigstens eine der folgenden umfassen: Kapazitiv, Induktiv, Ultraschall, Infrarot, Radar, Lidar, Optisch, Magnetfeld, Drucksensor, Temperatursensor und/oder Beschleunigungssensor. Die Sensoren können als eindimensionale Sensoren ausgebildet sein, welche beispielsweise die Entfernung oder die Geschwindigkeit in einer Richtung messen.

Darüber hinaus kann das jeweilige erfindungsgemäße Verfahren auch als ein computerimplementiertes Verfahren ausgeführt sein. Alternativ oder zusätzlich können jeder einzelne oder sämtliche der offenbarten Verfahrensschritte optional computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1:: eine schematische Darstellung einer möglichen Struktur für ein Maschinenlernmodell gemäß Ausführungsvarianten der Erfindung.
- Fig. 2:: eine weitere schematische Darstellung mit weiteren Einzelheiten zur Struktur für das Maschinenlernmodell gemäß Ausführungsvarianten der Erfindung.
- Fig. 3:: eine schematische Darstellung einer Detektionsauswertung.
- Fig. 4:: eine schematische Draufsicht auf ein Fahrzeug und ein System gemäß Ausführungsvarianten der Erfindung.
- Fig. 5:: eine schematische Ansicht eines feststehenden Türgriffs.
- Fig. 6:: schematische Darstellungen zur Visualisierung von Ausführungsvarianten der Erfindung.

In den nachfolgenden Figuren werden für die gleichen technischen Merkmale auch von unterschiedlichen Ausführungsbeispielen die identischen Bezugszeichen verwendet.

Es ist bekannt, dass Fahrzeuge anstelle von mechanisch zu betätigenden Türgriffen auch Zugangsvorrichtungen wie feststehende Türgriffe aufweisen können, bei welchen eine Betätigung durch eine Sensorerfassung detektiert wird. Allerdings kann die Sensorerfassung je nach Umgebungsbedingungen störanfällig sein. Es kann daher vorgesehen sein, dass Störungen detektiert werden, um in Abhängigkeit von dem Vorliegen einer Störung die Detektion anzupassen. Gemäß Ausführungsvarianten der Erfindung ist es außerdem vorgesehen, dass die Detektion der Betätigung der Zugangsvorrichtung 10 zusätzlich auf Basis der Klassifizierung der Art einer detektierten Störung angepasst, ausgeführt und damit robuster wird. Hierzu kann eine Auswertung der Sensorsignale vorgesehen sein, die durch Sensoren an der Zugangsvorrichtung 10 ausgegeben werden. Die Auswertung kann bevorzugt durch ein Maschinenlernmodell durchgeführt werden.

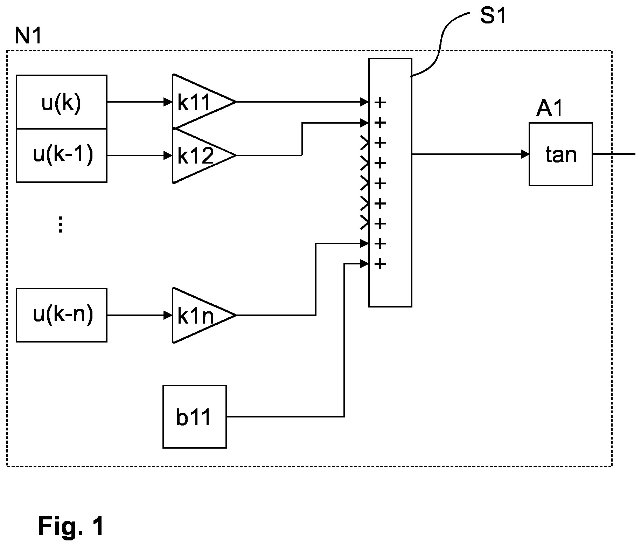

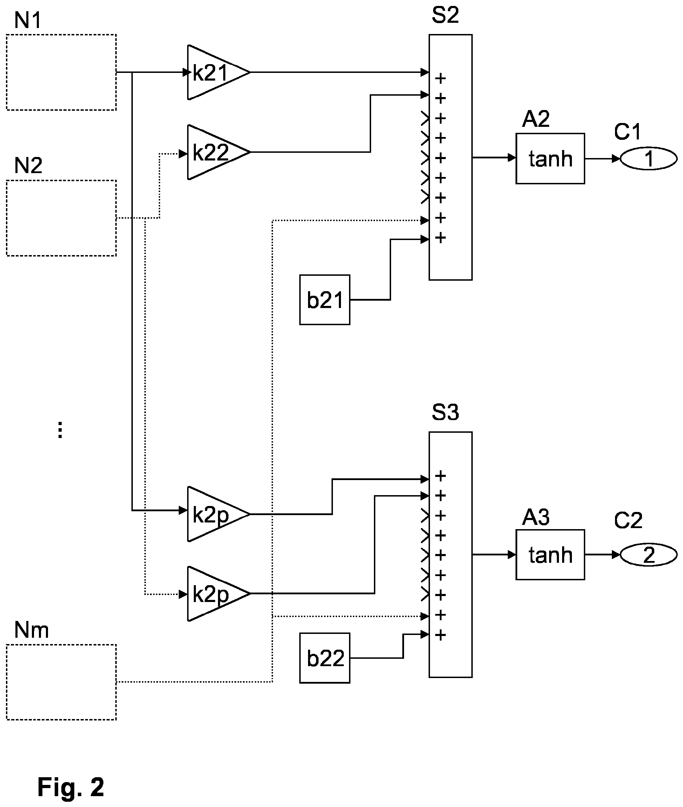

Die in Fig. 1 und 2 dargestellte Struktur eines künstlichen neuronalen Netzwerkes hat sich als bevorzugte Ausführungsvariante für ein erfindungsgemäßes Maschinenlernmodell herausgestellt. In Fig. 1 ist beispielhaft die Struktur eines Neurons N1 des Maschinenlernmodells gezeigt, welches in Fig. 2 gemeinsam mit weiteren Neuronen N und Strukturen des Netzwerks dargestellt wird. Die Eingaben *u*(*k*), *u*(*k* - 1) und *u*(*k* - *n*) stellen die verschiedenen Eingangswerte dar, die in das Neuron eingespeist werden. Für die Eingaben können insbesondere aufeinanderfolgende Samples der Sensorsignale verwendet werden. Jeder dieser Eingänge ist mit einem entsprechenden Gewicht *k*₁₁, *k*₁₂ bzw. *k*_{1*n*} versehen, welche die Bedeutung der jeweiligen Eingabe für die Verarbeitung innerhalb des Neurons *N* steuern.

Die gewichteten Eingaben können sodann in einer Summationseinheit *S*1 summiert werden. Zusätzlich kann ein Bias *b*₁₁ hinzugefügt werden, um die Summe der gewichteten Eingaben zu verschieben und somit die Flexibilität des Modells zu erhöhen. Das Ergebnis der Summation kann anschließend einer Aktivierungsfunktion *A*1, beispielsweise der hyperbolischen Tangensfunktion *tanh,* zugeführt werden, welche die Ausgabe des Neurons N1 generiert.

Fig. 2 illustriert eine weiterführende Struktur mit mehreren Neuronen *N* in einer Schicht, die als Ausführungsvariante des Maschinenlernmodells dienen kann. Diese Darstellung zeigt eine Schicht von Neuronen, darunter *N*1, *N*2 bis hin zu *Nm,* die miteinander verbunden sein können.

Für jedes Neuron *N* in dieser Schicht kann es gemäß der in Fig. 1 gezeigten Neuronenstruktur Eingaben und entsprechende Gewichte geben, wie zum Beispiel *k*₂₁, *k*₂₂ bis hin zu *k*_{2*p*}, die die Eingaben für die jeweiligen Neuronen *N* steuern. Diese gewichteten Eingaben werden in Summationseinheiten *S*2 und *S*3 summiert. Jedem Neuron *N* ist optional ein Bias-Wert *b*₂₁ bzw. b_22 zugeordnet, um die Summe der gewichteten Eingaben anzupassen.

Die Summationsergebnisse können dann durch Aktivierungsfunktionen *A*2 und *A*3 (beispielsweise *tanh*) geleitet werden, um die Ausgaben *C*1 und *C*2 zu erzeugen. Diese Ausgaben repräsentieren die endgültigen Ausgaben der Neuronen nach der Aktivierung und können als das Ergebnis des Klassifizierung, d.h. insbesondere als die Angabe der Art der Störung, verwendet werden.

Diese beschriebene Struktur des Maschinenlernmodells ist lediglich eine beispielhafte Ausführung der Erfindung und kann je nach Anwendungsfall modifiziert und angepasst werden.

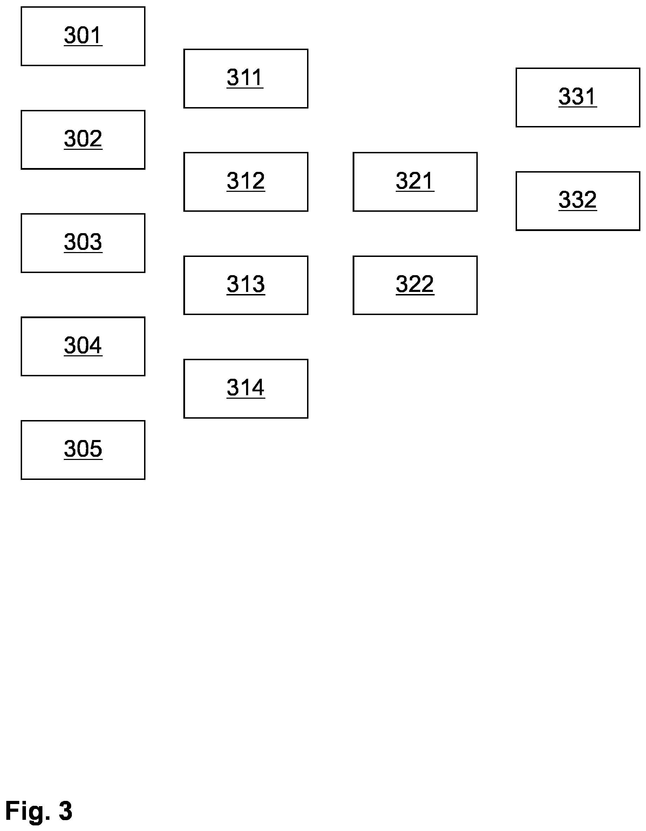

Fig. 3 zeigt ein Beispiel für ein System zur Detektion einer Betätigung und zur Verarbeitung der Sensorsignale, insbesondere in der Form von digitalen Sensordaten. Die Sensoren 301 bis 305 können verschiedene Arten von Sensoren umfassen, vorzugsweise kapazitive und induktive Sensoren. Diese Rohdaten der Sensoren, also die digitalen Sensorsignale, werden dann an die Verarbeitungsschritte 311 bis 314 weitergereicht. In welchem Ausmaße, d.h. mit welcher Gewichtung, die Weiterleitung pro Sensor erfolgt, kann bspw. durch die Beurteilungsfaktoren variabel festgelegt sein.

Der Verarbeitungsschritt 311 kann eine Merkmalsextraktion umfassen, wobei vorzugsweise ein Algorithmus wie die Hauptkomponentenanalyse (PCA) verwendet wird, der auf einem Mikrocontroller implementiert werden kann, um relevante Merkmale aus den Sensordaten zu extrahieren. Anschließend erfolgt im Schritt 312 eine Signalfilterung, die bevorzugt einen digitalen Butterworth-Filter verwenden kann, um die Signale zu glätten und hochfrequentes Rauschen zu entfernen.

Im nächsten Schritt 313 kann eine Rauschdetektion stattfinden, wobei ein Schwellenwertverfahren zur Erkennung ungewöhnlicher Signalspitzen vorzugsweise zum Einsatz kommt. Darauf folgt der Schritt 314, in dem die Rauschklassifikation vorgenommen wird. Hier kann ein Algorithmus wie der k-Nearest Neighbors (k-NN) zur Klassifikation des Rauschens basierend auf den extrahierten Merkmalen bevorzugt eingesetzt werden.

Die verarbeiteten Daten können anschließend an die weiteren Verarbeitungsschritte 321 und 322 weitergeleitet werden. Der Schritt 321 kann eine Auswertung umfassen, wobei vorzugsweise ein Entscheidungsbaum die Daten analysiert und die Sensoren individuell dekodiert. Alternativ kann auch eine einfachere Methode wie die lineare Regression oder die arithmetische Mittelwertbildung verwendet werden, die auf einem Mikrocontroller effizient ausgeführt werden können. In Schritt 322 kann die Dekodierung der Daten erfolgen, um die relevanten Informationen zu extrahieren. Dabei kann z. B. eine Support Vector Machine (SVM) verwendet werden, um Muster in den Daten zu erkennen und zu interpretieren. Eine weitere Alternative kann hier ein Schwellenwert-basierter Entscheidungsalgorithmus oder ein Mehrheitsentscheidungsalgorithmus sein, die ebenfalls auf einem Mikrocontroller ausgeführt werden können.

Schließlich können die Ergebnisse der Verarbeitung an die Schritte 331 und 332 weitergeleitet werden. Schritt 331 kann eine Referenzprüfung umfassen, bei der die ausgewerteten und dekodierten Daten mit vordefinierten Merkmalen verglichen werden. Vorzugsweise kann hier eine Tabelle/Datenbank mit bekannten Mustern verwendet werden, um die Ergebnisse zu validieren. Im letzten Schritt 332 kann basierend auf dem Vergleich mit der Referenz eine finale Entscheidung getroffen werden, ob eine Störung vorliegt.

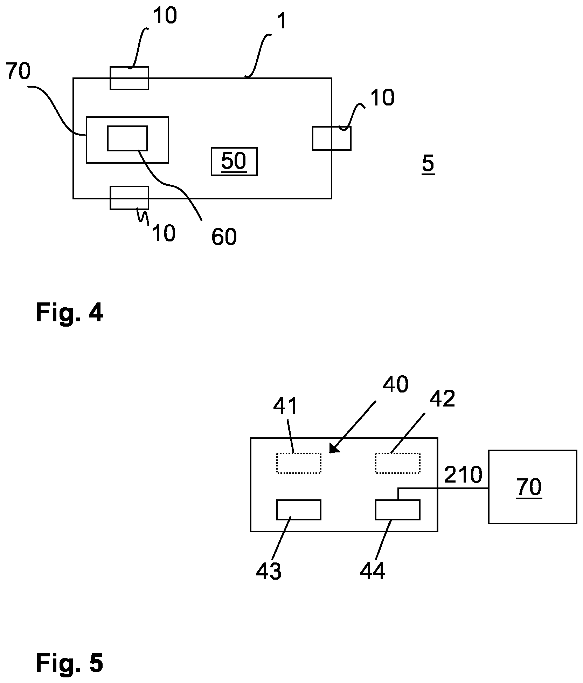

In Fig. 4 ist ein System mit einem Fahrzeug 1, mehreren Zugangsvorrichtungen 10 sowie einem Computerprogramm 60 und einer Vorrichtung 70 zur Datenverarbeitung dargestellt. Darüber hinaus ist auch ein Maschinenlernalgorithmus 50 gezeigt, welcher im Fahrzeug 1 durch die oder eine weitere Vorrichtung 70 zur Datenverarbeitung bereitgestellt werden kann. Fig. 5 zeigt ferner einen beispielhaften Aufbau einer Zugangsvorrichtung 10 mit mehreren Sensoren 40 (bspw. 41,42,43,44), welche zur Übertragung der Sensorsignale 210 mit der Vorrichtung 70 verbunden sind.

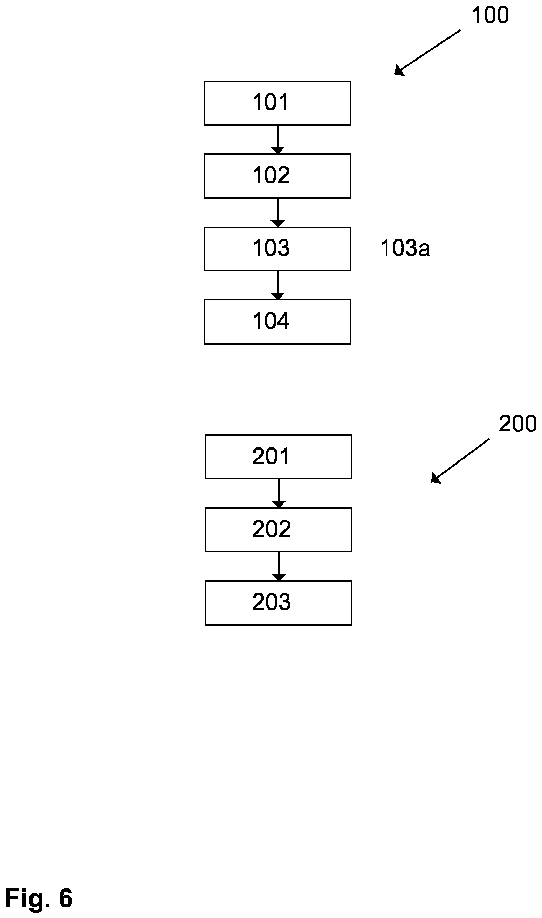

Fig. 6 veranschaulicht gemäß Ausführungsbeispielen der Erfindung das Verfahren 100 zur Detektion der Betätigung der Zugangsvorrichtung 10 des Fahrzeuges 1. Die Detektion der Betätigung kann dabei in Abhängigkeit von Beurteilungsfaktoren vorgesehen sein. Gemäß einem ersten Verfahrensschritt 101 kann ein Bereitstellen von Sensorsignalen 210 erfolgen, welche aus einer Sensorerfassung am Fahrzeug 1 resultieren. Gemäß einem zweiten Verfahrensschritt 102 kann ein Detektieren einer Störung durch wenigstens einen Einfluss aus einer Umgebung 5 des Fahrzeuges 1 erfolgen. Die Störung ist insbesondere als eine solche definiert, welche geeignet ist, die Detektion der Betätigung zu beeinträchtigen. Sodann kann gemäß einem dritten Verfahrensschritt 103 ein Klassifizieren einer Art der detektierten Störung durch eine Auswertung 103a der bereitgestellten Sensorsignale 210 vorgenommen werden. Dies ermöglicht gemäß einem vierten Verfahrensschritt 104 eine Anpassung der Beurteilungsfaktoren für die Detektion der Betätigung auf Basis der Klassifizierung 103.

Ferner ist in Fig. 6 ein Trainingsverfahren 200 für ein Training eines Maschinenlernmodells 50 zur Klassifizierung einer Art einer Störung durch wenigstens einen Einfluss aus einer Umgebung 5 eines Fahrzeuges 1 dargestellt. Das Trainingsverfahren 200 kann gemäß einem ersten Trainingsschritt 201 ein Bereitstellen von Trainingsdaten umfassen. Die Trainingsdaten können dabei mehrere Sensorsignale 210 umfassen, die für jeweilige Sensorerfassungen von verschiedenen Sensoren 41,42,43,44 bei einer Zugangsvorrichtung 10 des Fahrzeuges 1 spezifisch sind (vgl. Fig. 5). Dabei können die Trainingsdaten ferner den Sensorsignalen 210 zugeordnete Referenzdaten umfassen, welche eine Art der Störung angeben, die bei der jeweiligen Sensorerfassung vorgesehen war. Außerdem kann gemäß einem zweiten Trainingsschritt 102 ein Trainieren des Maschinenlernmodells 50 auf Basis der bereitgestellten Trainingsdaten vorgesehen sein. In einem dritten Trainingsschritt 103 kann ein Bereitstellen 203 des trainierten Maschinenlernmodells 50 für die Klassifizierung 103 der Art einer beim Fahrzeug 1 detektierten Störung erfolgen.

Das Bereitstellen der Trainingsdaten im ersten Trainingsschritt 201 kann beispielsweise das Sammeln und Vorverarbeiten von Daten umfassen. Hierbei können die Daten in strukturierter Form vorliegen. Um die Daten für das Training nutzbar zu machen, können verschiedene Vorverarbeitungsschritte durchgeführt werden, wie beispielsweise Datenbereinigung, Normalisierung und Feature-Engineering. Im zweiten Trainingsschritt 102 kann das Maschinenlernmodell 50 unter Verwendung verschiedener Parameter und Hyperparameter trainiert werden. Dazu zählen die Wahl der Modellarchitektur, wie z.B. eines neuronalen Netzwerks, eines Entscheidungsbaums oder einer Support-Vektor-Maschine, sowie die Festlegung von Hyperparametern wie der Lernrate, der Anzahl der Epochen und der Batchgröße. Für das Training des Modells kann ein geeignetes Framework wie TensorFlow, PyTorch oder Scikit-learn verwendet werden. Eine bevorzugte Modellarchitektur ist dabei ein einfaches neuronales Netz mit beispielsweise zwei Layern.

Der Trainingsprozess kann in mehreren Iterationen erfolgen, wobei in jeder Iteration das Modell auf Basis eines Teils der Trainingsdaten angepasst wird. Zur Evaluierung der Modellleistung können Validierungsdaten verwendet werden, die nicht im Trainingsprozess enthalten sind, um Overfitting zu vermeiden und die Generalisierungsfähigkeit des Modells zu überprüfen.

In dem dritten Trainingsschritt 103 kann das trainierte Maschinenlernmodell 50 bereitgestellt werden. Dies umfasst bspw. das Speichern des Modells in einem geeigneten Format, wie z.B. einem H5-Datei für neuronale Netzwerke. Auch kann eine Umwandlung in ein für ein Mikrocontroller geeignetes und ggf. nach Kompilierung ausführbares Format vorgesehen sein, z. B. in einen C-Code.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 5: Umgebung

- 10: Zugangsvorrichtung

- 40: Sensor
- 41: erster Sensor
- 42: zweiter Sensor
- 43: dritter Sensor
- 44: vierter Sensor

- 50: Maschinenlernmodell

- 60: Computerprogramm

- 70: Vorrichtung

- 100: Verfahren
- 101: erster Verfahrensschritt
- 102: zweiter Verfahrensschritt
- 103: dritter Verfahrensschritt
- 104: vierter Verfahrensschritt

- 200: Trainingsverfahren
- 201: erster Trainingsschritt
- 202: zweiter Trainingsschritt
- 203: dritter Trainingsschritt
- 210: Sensorsignalen

- k: Gewichte der jeweiligen Eingänge
- u(k): Eingangswert zum Zeitpunkt k
- 41,42,43,44: Sensoren
- A: Aktivierungsfunktion
- C: Ausgaben, Klassifizierungsergebnis
- Nm: Neuronen in der Schicht
- S: Summationseinheit
- b: Bias-Wert

## Patentansprüche

1. Verfahren (100) zur Detektion einer Betätigung einer Zugangsvorrichtung (10) eines Fahrzeuges (1), wobei die Detektion der Betätigung in Abhängigkeit von Beurteilungsfaktoren vorgesehen ist, umfassend:
- Bereitstellen (101) von Sensorsignalen (210), welche aus einer Sensorerfassung am Fahrzeug (1) resultieren,
- Detektieren (102) einer Störung durch wenigstens einen Einfluss aus einer Umgebung (5) des Fahrzeuges (1), welche geeignet ist, die Detektion der Betätigung zu beeinträchtigen,
- Klassifizieren (103) einer Art der detektierten Störung durch eine Auswertung (103a) der bereitgestellten Sensorsignale (210),
- Anpassen (104) der Beurteilungsfaktoren für die Detektion der Betätigung auf Basis der Klassifizierung (103).

2. Verfahren (100) nach Anspruch 1,
**dadurch gekennzeichnet,**
**dass** das Anpassen (104) der Beurteilungsfaktoren für die Detektion der Betätigung auf Basis der Klassifizierung (103) eine Optimierung der Beurteilungsfaktoren hinsichtlich der Art der Störung umfasst, welche zusätzlich und nachfolgend zu einer ersten Anpassung der Beurteilungsfaktoren durchgeführt wird,
wobei vor der Detektion (102) der Störung die Beurteilungsfaktoren derart eingestellt sind, dass die Detektion der Betätigung mit einer normalen Sensitivität erfolgt, um die Zugangsvorrichtung (10) zu aktivieren, wenn die Betätigung erkannt worden ist, wobei ausgelöst durch die Detektion (102) der Störung die erste Anpassung der Beurteilungsfaktoren erfolgt, um in einem gestörten Modus die Detektion der Betätigung in einen robusteren Modus zu überführen, in welchem vorzugsweise die Detektion der Betätigung mit einer geringeren Sensitivität erfolgt und/oder die Aktivierung der Zugangsvorrichtung (10) vorrübergehend unterdrückt wird, wobei nach der Überführung in den robusteren Modus zusätzlich die Klassifizierung (103) der Art der detektierten Störung erfolgt, und auf Basis der Klassifizierung (103) die Beurteilungsfaktoren hinsichtlich der Art der Störung optimiert werden, wobei vorzugsweise zur Detektion der Betätigung eine Detektionsauswertung zumindest eines Teils der bereitgestellten Sensorsignale (210) in Abhängigkeit von den Beurteilungsfaktoren durchgeführt wird.

3. Verfahren (100) nach einem der vorhergehenden Ansprüche,
**dadurch gekennzeichnet,**
**dass** die Sensorerfassung durch mehrere Sensoren (41,42,43,44) am Fahrzeug (1) vorgesehen ist, welche sich hinsichtlich ihrer Sensortechnologie und/oder ihrer Anordnung am Fahrzeug (1) unterscheiden, um den wenigstens einen Einfluss aus der Umgebung und insbesondere auch wenigstens eine Betätigungshandlung für die Detektion der Störung und/oder Betätigung zu erfassen, wobei die Sensoren (41,42,43,44) hierzu bevorzugt an der Zugangsvorrichtung (10) angeordnet sind.

4. Verfahren (100) nach Anspruch 3,
**dadurch gekennzeichnet,**
**dass** das Anpassen (104) der Beurteilungsfaktoren für die Detektion der Betätigung ferner umfasst:
- Anpassen einer Detektionsgewichtung, mit welcher die Sensorsignale (210) von unterschiedlichen Sensoren (41,42,43,44) für die Detektion der Betätigung berücksichtigt werden.

5. Verfahren (100) nach Anspruch 4,
**dadurch gekennzeichnet,**
**dass** bei dem Anpassen der Detektionsgewichtung diejenigen der Sensorsignale (210), welche von einer ersten Sensorerfassung wenigstens eines ersten Sensors (41) resultieren, die stärker durch den wenigstens einen Einfluss beeinträchtig wird, geringer gewichtet werden als diejenigen der Sensorsignale (210), welche von einer zweiten Sensorerfassung wenigstens eines zweiten Sensors (42) resultieren, die weniger als die erste Sensorerfassung durch den wenigstens einen Einfluss beeinträchtig wird.

6. Verfahren (100) nach einem der Ansprüche 3 bis 5,
**dadurch gekennzeichnet,**
**dass** das Klassifizieren (103) der Art der detektierten Störung ferner umfasst:
- Verwenden einer unterschiedlichen Gewichtung in Abhängigkeit von der zu klassifizierenden Art der detektierten Störung, mit welcher die Sensorsignale (210) von unterschiedlichen Sensoren (41,42,43,44) bei der Auswertung (103a) berücksichtigt werden, um die Art der detektierten Störung zu ermitteln.

7. Verfahren (100) nach Anspruch 6,
**dadurch gekennzeichnet,**
**dass** für die verschiedenen Arten von Störungen unterschiedliche Gewichtungsvorgaben definiert sind, mit welchen die Sensorsignale (210) zur Ermittlung der Art der detektierten Störung ausgewertet werden, wobei hierzu vorzugsweise bei dem Klassifizieren (103) diejenigen der Sensorsignale (210), welche von einer ersten Sensorerfassung wenigstens eines ersten Sensors (41) resultieren, die stärker durch die zu klassifizierende Art der detektierten Störung beeinträchtig wird, höher gewichtet werden als diejenigen der Sensorsignale (210), welche von einer zweiten Sensorerfassung wenigstens eines zweiten Sensors (42) resultieren, die weniger als die erste Sensorerfassung durch die zu klassifizierende Art der detektierten Störung beeinträchtig wird.

8. Verfahren (100) nach einem der Ansprüche 3 bis 7,
**dadurch gekennzeichnet,**
**dass** für die Sensorsignale (210) von unterschiedlichen Sensoren (41,42,43,44) jeweils die Auswertung (103a) durchgeführt wird, um für jeden Sensor (40) die Klassifizierung individuell durchzuführen, wobei anschließend die Ergebnisse der Klassifizierungen verglichen werden, um zu entscheiden, welche Art der Störung vorliegt.

9. Verfahren (100) nach einem der vorhergehenden Ansprüche,
**dadurch gekennzeichnet,**
**dass** die zu klassifizierende Art der zu detektierenden Störung zumindest eine der folgenden umfasst: Regen, Hagel, Schnee, Vibration, mechanische Einwirkungen wie eine Reinigungsbewegung, Spritzwasser, Feuchtigkeit, Luftturbulenzen, Blätter, Tiere, Objekte.

10. Verfahren (100) nach einem der vorhergehenden Ansprüche,
**dadurch gekennzeichnet,**
**dass** die Zugangsvorrichtung (10) als ein feststehender Türgriff ausgebildet ist und/oder wenigstens eine Aktivierungsvorrichtung zur Aktivierung einer Tür und/oder Klappe, vorzugsweise Heckklappe, des Fahrzeuges (1) umfasst, wobei die Sensorsignale von mehreren Sensoren resultieren, wobei jeder Sensor ein individuelles Sensorsignal liefert, und dass bei der Detektion der Betätigung und/oder bei der Auswertung (103a) diesen Sensorsignalen unterschiedliche Beurteilungsfaktoren zugewiesen werden, welche die relative Bedeutung der Sensorsignale für die Detektion repräsentieren, wobei vorzugsweise die Sensoren zumindest einen der folgenden umfassen: kapazitive Sensoren, induktive Sensoren, Dehnungsmessstreifen, Metallannäherungssensoren, optische Sensoren, Thermoelemente, Drucksensoren und Näherungssensoren.

11. Verfahren (100) nach einem der vorhergehenden Ansprüche,
**dadurch gekennzeichnet,**
**dass** wenigstens ein erster Sensor (40) für eine erste Sensorerfassung außenliegend an der Zugangsvorrichtung (10) angeordnet ist, um als eine Betätigungshandlung zur Detektion der Betätigung eine Berührung und/oder ein Drücken an der Zugangsvorrichtung (10) zu erfassen, durch welche bei erfolgreicher Detektion der Betätigung eine Entriegelung und/oder Verriegelung und/oder ein automatisches Türschließen initiiert wird,
wobei wenigstens ein zweiter Sensor (40) für eine zweite Sensorerfassung innenliegend an der Zugangsvorrichtung (10) angeordnet ist, um als eine Betätigungshandlung zur Detektion der Betätigung ein Eingreifen und/oder Ziehen an der Zugangsvorrichtung (10) zu erfassen, durch welche bei erfolgreicher Detektion der Betätigung eine Entriegelung und/oder ein automatisches Türöffnen initiiert wird.

12. Verfahren (100) nach einem der vorhergehenden Ansprüche,
**dadurch gekennzeichnet,**
**dass** die jeweilige Auswertung (103a) durch ein Maschinenlernmodell (50) durchgeführt wird, welches vorzugsweise in der Form eines flachen neuronalen Netzwerkes und/oder eines neuronalen Netzwerkes mit maximal zehn/fünf/zwei Schichten, vorzugsweise einer Eingabe- und einer Ausgabeschicht, ausgebildet ist.

13. Verfahren (100) nach Anspruch 12,
**dadurch gekennzeichnet,**
**dass** das Maschinenlernmodell (50) durch einen Mikrocontroller ausgeführt wird, welcher vorzugsweise in die Zugangsvorrichtung (10) integriert ist.

14. Verfahren (100) nach Anspruch 12 oder 13,
**dadurch gekennzeichnet,**
**dass** für die jeweilige Auswertung (103a) als Eingabe für das Maschinenlernmodell (50) mindestens 100 oder mindestens 200 oder mindestens 300 zeitlich aufeinanderfolgende Samples der Sensorsignale (210) verwendet werden, wobei die Samples vorzugsweise in zeitlichen Abständen von 1 bis 10 ms, vorzugsweise 3 bis 7 ms erfasst werden.

15. Verfahren (100) nach einem der Ansprüche 12 bis 14,
**dadurch gekennzeichnet,**
**dass** eine Anzahl der Neuronen der Eingabeschicht in Abhängigkeit von einer Anzahl der als Eingabe verwendeten Samples definiert wird, und dass eine Anzahl der Neuronen der Ausgabeschicht in Abhängigkeit von der Anzahl der zu klassifizierenden Arten der Störung definiert wird.

16. Trainingsverfahren (200) für ein Training eines Maschinenlernmodells (50) zur Klassifizierung einer Art einer Störung durch wenigstens einen Einfluss aus einer Umgebung (5) eines Fahrzeuges (1), umfassend:
- Bereitstellen (201) von Trainingsdaten, wobei die Trainingsdaten mehrere Sensorsignale (210) umfassen, die für jeweilige Sensorerfassungen von verschiedenen Sensoren (41,42,43,44) bei einer Zugangsvorrichtung (10) des Fahrzeuges (1) spezifisch sind, und wobei die Trainingsdaten den Sensorsignalen (210) zugeordnete Referenzdaten umfassen, welche eine Art der Störung angeben, die bei der jeweiligen Sensorerfassung vorgesehen war,
- Trainieren (202) des Maschinenlernmodells (50) auf Basis der bereitgestellten Trainingsdaten,
- Bereitstellen (203) des trainierten Maschinenlernmodells (50) für die Klassifizierung (103) der Art einer beim Fahrzeug (1) detektierten Störung.

17. Maschinenlernmodell (50), welches durch ein Trainingsverfahren (200) nach Anspruch 16 trainiert worden ist.

18. Computerprogramm (60), umfassend Befehle, die bei der Ausführung des Computerprogramms (60) durch einen Computer (70) diesen veranlassen, das Verfahren nach einem der vorhergehenden Ansprüche auszuführen.

19. Vorrichtung (70) zur Datenverarbeitung, die eingerichtet ist, das Verfahren (100) nach einem der Ansprüche 1 bis 15 auszuführen.

20. System zur Detektion einer Betätigung einer Zugangsvorrichtung (10) eines Fahrzeuges (1), wobei die Detektion der Betätigung in Abhängigkeit von Beurteilungsfaktoren vorgesehen ist, aufweisend
- mehrere Sensoren (41,42,43,44) verschiedener Art, welche zur Erfassung einer Umgebung des Fahrzeuges (1) über verschiedene Erfassungsprinzipien vorgesehen sind, um über die Sensorerfassung jeweils Sensorsignale (210) bereitzustellen,
- eine Vorrichtung (70) zur Datenverarbeitung, welche die bereitgestellten Sensorsignale (210) erfasst und dazu ausgeführt ist, für die Anpassung (104) der Beurteilungsfaktoren das Verfahren (100) nach einem der Ansprüche 1 bis 15 auszuführen.
